# EUROPÄISCHE PATENTANMELDUNG

(11) **EP 1 058 416 A2**
(43) Veröffentlichungstag der Anmeldung: **06.12.2000**
(21) Anmeldenummer: 00111387.7
(22) Anmeldetag: 26.05.2000
(51) Int. Cl.: H04L 7/033, H04L 25/24

(54) **Vorrichtung zur Unterdrückung von Jittern in Taktregenerierungseinrichtungen**

(30) Priorität: 31.05.1999 DE 19924987
(71) Anmelder: SIEMENS AKTIENGESELLSCHAFT, 80333 München (DE)
(72) Erfinder: Mariggis, Athanase, 81379 München (DE)

(57) **Zusammenfassung**

Bei zeitgemäßen Kommunikationssystemen können die in digitalen, hochgenauen Taktregenerierungseinrichtungen auftretenden Jitter nicht toleriert werden. Der Jitter verursacht bei der digitalen Bitfolgenbildung eine periodische Bitverzerrung wodurch in einer regelmäßigen Abfolge alle 2 Bits lange bzw. kurze Bitimpulse entstehen. Zur Lösung dieses Problems wird eine Steuerlogik vorgesehen, die Bits paarweise zusammenfügt und beim Auftreten von 2 gleichen, unterschiedliche Bit aufweisenden Bitpaaren ( 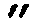 01" oder 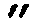 10") das später ankommende Bitpaar durch das dazu invertiertes Bitpaar ersetzt.

## Beschreibung

Die Erfindung betrifft eine Vorrichtung gemäß dem Oberbegriff von Patentanspruch 1.

Zeitgemäße Kommunikationssysteme weisen in der Regel digitale Taktregenerierungseinrichtungen auf, die einen über das Kommunikationsnetz übertragenen Referenztakt empfangen und in entsprechender Weise regenerieren. Dies gilt insbesondere auch für Kommunikationssysteme, die ATM-Informationssignale durchschalten. Beim Stand der Technik wird hierzu ein hochgenaues VCXO-Element (Voltage Controlled Crystal Oscillator) verwendet, das durch eine als ASIC ausgebildete Steuereinheit angesteuert wird. Die Steuereinheit weist einen Phasendetektor auf, der einen möglichen Phasenunterschied zwischen dem extern zugeführten Referenztakt und dem lokal erzeugten Takt ermittelt und nach Maßgabe der ermittelten Phasendifferenz eine Bitfolge erzeugt. Diese Bitfolge ist ähnlich einer PWM-Steuerung (PWM = Pulse Wide Modulation) ausgebildet. Die derart erzeugte Bitfolge wird nun über ein nachfolgendes Loop-Filter integriert und dadurch in eine analoge VCXO-Steuerspannung umgewandelt, die im folgenden dem hochgenauen VCXO-Element zugeführt wird.

Internationale Normierungsgremien definieren feste Vorgaben bezüglich der Genauigkeit der abgegebenen Takte, um beim Ausfall des Referenztaktes die Informationssignale noch schlupffrei übertragen zu können. Um diesen Vorgaben gerecht zu werden wurde beim Stand der Technik eine zusätzliche PLL-Schaltung (Phased Locked Loop) in den Rückkoppelkreis zwischen dem VCXO-Element und der Steuereinheit eingefügt. Dadurch wird die von dem VCXO-Element abgegebene Taktfrequenz aufgenommen, verdoppelt und die derart verdoppelte Taktfrequenz der Steuereinheit zugeführt.

Problematisch an dieser Anordnung ist, daß PLL-Schaltungen generell einen unvermeidbaren regelmäßigen Jitter erzeugen. Dieser beträgt etwa die Hälfte der Taktfrequenz, was bei hochgenauen Taktregenerierungseinrichtungen, wie sie in Kommunikationssystemen eingesetzt werden, nicht mehr toleriert werden kann. Der Jitter verursacht bei der PWM-Bitfolgenbildung eine periodische Bitverzerrung. Dabei entstehen in einer regelmäßigen Abfolge alle zwei Bits lange bzw. kurze Bitimpulse. Dies bedeutet beispielsweise für eine PWM-Bitfolge "10101010...", daß infolge des Auftretens des Jitters das Loop-Filter ein immer längeres 'High' und kürzeres 'Low' zugeführt bekommt. Die daraus gewonnene VCXO-Steuerspannung ist damit ungleich der maximalen Spannung/2, wie sie am Eingang des VCXO-Elementes für die Abgabe eines hochgenauen Taktes erforderlich wäre. Wegen dieses Problems können somit die standardisierten Genauigkeitswerte nicht optimal erreicht werden.

Zur Lösung dieses Problems wurden beim Stand der Technik Jitterkorrekturschaltungen eingesetzt. Hierzu wurden beispielsweise Scrambler vorgeschlagen, die jedoch einen hohen Schaltungs- und Entwicklungsaufwand verursachen.

Der Erfindung liegt die Aufgabe zugrunde, eine Vorrichtung anzugeben, mit Jitterkorrekturen mit relativ einfachen Mitteln realisiert werden können.

Die Erfindung wird, ausgehend von den im Oberbegriff von Patentanspruch 1 angegebenen Merkmalen durch die im kennzeichnenden Teil angegebenen Merkmale gelöst.

Vorteilhaft an der Erfindung ist insbesondere das Vorsehen einer Steuerlogik, die in den Rückkoppelkreis der Taktregeneriervorrichtung eingefügt wird. Diese ermittelt das Auftreten der Jitter und nimmt bereits bei zweimaligem Auftreten hintereinander dann eine Korrektur vor, wenn die Gefahr des Aufsummierens besteht. Dies ist immer dann der Fall, wenn 2 gleiche, unterschiedliche Bit aufweisenden Bitpaaren ( 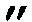 01" oder 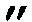 10") hintereinander auftreten. Hier wird dann das später ankommende Bitpaar durch das dazu invertierte Bitpaar ersetzt. In allen anderen Fällen, also beim Auftreten von Bitpaaren mit dem logischen Wert 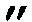 01" oder 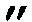 10" mitteln sich die Jitter auf der Bitebene automatisch raus. Beim Hintereinanderauftreten von Jittern in den Bitpaaren mit dem logischen Wert 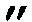 01" und 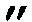 10" findet das Ausmitteln auf der Ebene des Bitpaares statt.

Vorteilhafte Ausgestaltungen der Erfindung sind in den Unteransprüchen angegeben.

Die Erfindung wird im folgenden anhand eines Ausführungsbeispiels näher erläutert.

Es zeigen:
- Figur 1: eine Taktregenerierungseinrichtung mit der erfindungsgemäßen Jitterkorrektureinrichtung
- Figur 2: drei anhand von Zeitdiagrammen erläuterte Fallbeispiele.

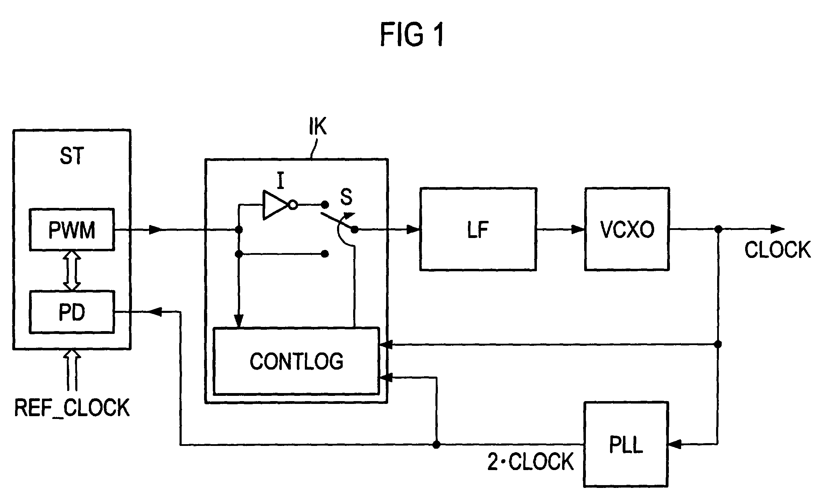

In Fig. 1 ist die erfindungsgemäße Vorrichtung offenbart. Demgemäß ist eine, einen Bitgenerator PWM sowie einen Phasendetektor PD aufweisende Steuereinheit ST aufgezeigt. Bitgenerator PWM sowie Phasendetektor PD stehen in Wirkverbindung miteinander. Der Steuereinheit ST wird ferner ein externer Referenztakt REF_CLOCK zugeführt. Wird vom Phasendetektor PD einen Phasendifferenz zwischen dem externen Referenztakt REF_CLOCK und dem von der erzeugten, auf die Steuereinheit ST rückgekoppelten Takt CLOCK ermittelt, so wird der Bitgenerator PWM angesteuert, der nach Maßgabe der Phasendifferenz eine entsprechende Bitfolge erzeugt.

Dem Bitgenerator PWM ist die erfindungsgemäße Jitterkorrektureinrichtung JK nachgeschaltet. Darin ist eine Schaltvorrichtung S angeordnet, die bei entsprechender Stellung wahlweise die vom Bitgenerator PWM abgegebene Bitfolge oder die hierzu invertierte Bitfolge aufnimmt. Letztere wird über einen Inverter I erzeugt. Die Ansteuerung der Schaltvorrichtung S erfolgt über eine Steuerlogik CONTLOG.

Der Jitterkorrektureinrichtung JK ist ein Loop-Filter LF sowie ein hochgenaues VCXO-Element VCXO nachgeschaltet. Das Loop-Filter LF weist die Funktion einer Integriereinrichtung auf, die die ankommende Bitfolge integriert und somit in eine analoge VCXO-Steuerspannung umwandelt. Diese Steuerspannung wird direkt dem VCXO-Element zugeführt, das aus dieser Spannung die gewünschte Taktfrequenz CLOCK erzeugt. Bei Nichtvorhandensein der Jitterkorrektureinrichtung JK würde die mit Jittern beaufschlagte Steuerspannung zu Schwankungen am Eingang des VCXO-Elementes führen.

Die am Ausgang des VCXO-Elementes gewonnene Taktfrequenz CLOCK wird dann weiteren Systemeinrichtungen zugeleitet. Parallel hierzu wird die Taktfrequenz CLOCK einer PLL-Schaltung PLL sowie einer Steuerlogik CONTLOG zugefürt. In der PLL-Schaltung PLL wird eine Frequenzverdoppelung vorgenommen, die ebenfalls der Steuerlogik CONTLOG sowie dem Phasendetektor PD der Steuereinheit ST zugeführt wird.

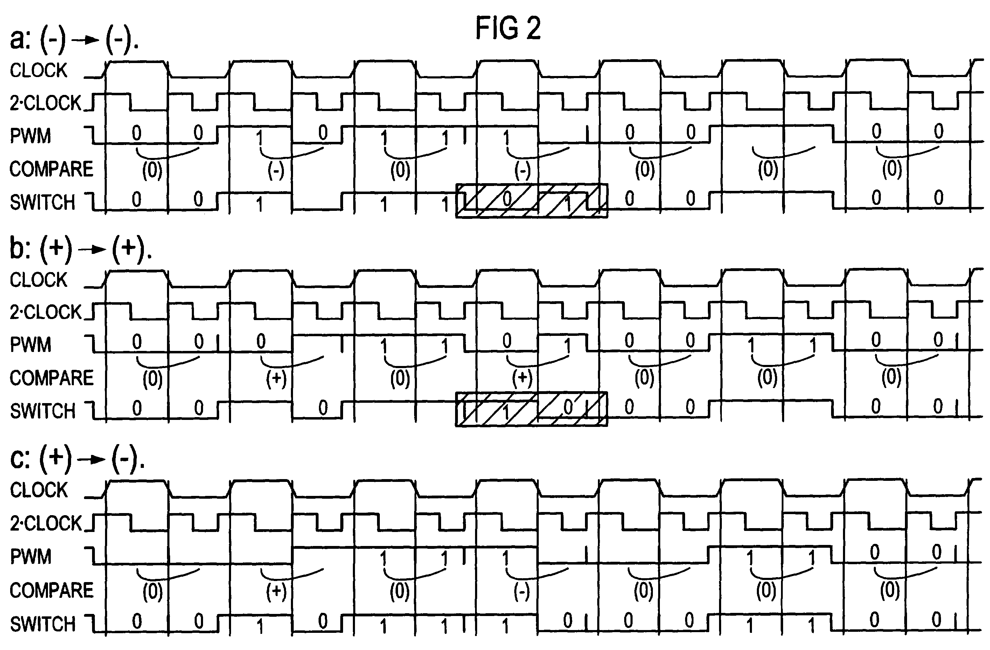

Die Funktionsweise der Vorrichtung sei im folgenden anhand von Fig. 2 näher erläutert. Als wesentlich ist anzusehen, daß die in der PLL-Schaltung PLL erzeugte doppelte Taktfrequenz 2*CLOCK in der Steuerlogik CONTLOG in Bitpaare geteilt wird. Dies bedeutet, daß jeweils 2 Bit zu einer Biteinheit zusammengefaßt werden. Das Aufteilen in Bitpaare ist jedoch nicht zwingend. So können beispielsweise auch andere beliebige Biteinheiten von n Bit zusammengefaßt werden.

Generell verursacht ein regelmäßiger Jitter zyklisch ein langes und ein kurzes Bit. Dies bedeutet, daß ohne Jitterkorrektur das Integrieren dieser Bit im Loop-Filter LF zu einer von der optimalen VCXO-Steuerspannung abweichenden Spannung führt. Da jeweils 2 Bit zusammengefaßt sind, verursachen 2 gleiche Bit wie 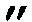 11" oder 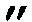 00" keine Ungenauigkeit in der VCXO-Steuerspannung. Insofern ist damit kein Handlungsbedarf im Sinne einer Jitterkorrektur gegeben. Bei zwei ungleichen Bit ist dies jedoch anders. Demzufolge wird von 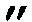 01" eine Ungenauigkeit in der VCXO-Steuerspannung verursacht. Diese Ungenauigkeit kann mit einem nachfolgenden Bitpaar 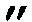 10" wieder korrigiert werden und umgekehrt.

Gemäß dem Fig. 2a aufgezeigten Zeitdiagramm ist als oberstes Diagramm die lokal erzeugte Taktfrequenz CLOCK erkennbar. Die in der PLL-Schaltung PLL verdoppelte Taktfrequenz 2*CLOCK sowie die daraus resultierende PWM-Bitfolge sind unterhalb dargestellt. Die jitterbehafteten Impulse 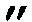 Lang", 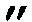 kurz" sind deutlich erkennbar. Zunächst wird davon ausgegangen, daß das zuerst gebildete Bitpaar den logischen Wert 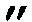 00" aufweist. Gemäß dem oben Gesagten besteht also hier kein Handlungsbedarf. Dies wird unterhalb der aufgezeigten PWM-Bitfolge durch die Markierung (0) signalisiert.

Das unmittelbar folgende Bitpaar weist den logischen Wert 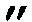 10" auf. Dieses wird in einer Vergleichseinrichtung COMPARE gespeichert. Dies bedeutet, daß ein Jitter aufgetreten ist, der später gegebenenfalls zu korrigieren ist. Dies wird durch die Markierung (-) signalisiert. Der Jitter ist immer dann zu korrigieren, wenn zu einem späteren Zeitpunkt erneut ein logischen Wert 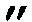 10" auftritt. Ist dies nicht der Fall, bestünde kein Handlungsbedarf, da beide Jitter sich beim Integrationsprozeß ausmitteln. Gemäß Fig. 2a weist das nächste Bitpaar den Wert 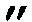 11" auf. An dieser Stelle besteht also ebenfalls kein Handlungsbedarf (Markierung (0)). Im folgenden kommt aber ein Bitpaar mit einem logischen Wert 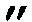 10". Da dies nun das zweite Auftreten eines derartigen Bitpaares ist, besteht die Gefahr, daß sich der Jittereffekt aufgrund der Integration im Loop-Filter LF aufsummiert.

Zur Korrektur wird nun die Schaltvorrichtung S angesteuert, die dieses Bitpaar in der Bitfolge invertiert empfängt. Damit ist am VCXO-Element nach der Integration kein Unterschied erkennbar, da der Jitter ausgemittelt wurde. Das 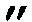 Umdrehen" der Bit ist in Fig. 2a dunkel markiert. Gemäß Fig. 2b sind die Verhältnisse aufgezeigt, wie sie beim Auftreten von 2 Bitpaaren 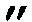 01" sich zeigen (Markierung (+)). Die Korrektur wird hier aufgund derselben Überlegungen vorgenommen, sie ist hier ebenfalls dunkel markiert.

Keinerlei Handlungsbedarf ist für die in Fig. 2c aufgezeigten Verhältnisse gegeben. Da hier die 2 Bitpaare 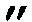 10" und 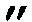 01" aufeinanderfolgen, findet beim anschließenden Integrationsprozeß ein Ausmitteln statt, es bedarf somit keines Ansteuern der Schaltvorrichtung S.

## Patentansprüche

1. Vorrichtung zur Unterdrückung von Jittern in digitalen Taktregenerierungseinrichtungen,
die eine Steuereinrichtung (ST) zum Aussenden einer nach Maßgabe der Phasendifferenz zwischen einem ersten und zweiten Takt gebildeten Bitfolge aufweisen, welche einer Takterzeugungsvorrichtung (VCXO) zugeführt wird, und die Mittel zum Rückkoppeln des zweiten Taktes auf die Steuereinrichtung (ST) aufweisen,
**dadurch gekennzeichnet,**
daß in die Mittel zum Rückkoppeln eine Steuerlogik (CONTLOG) eingefügt ist, die die Bitfolge mit Hilfe des zweiten Taktes (CLOCK) in Bitpaare teilt, und die beim hintereinander Auftreten von zwei gleichen, unterschiedliche Bit aufweisenden Bitpaaren ( 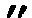 01" oder 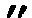 10") das später ankommende Bitpaar durch das dazu invertierte Bitpaar ersetzt.

2. Vorrichtung nach Anspruch 1,
**dadurch gekennzeichnet,**
daß der erste Takt (REF_CLOCK) der Referenztakt und der zweite Takt (CLOCK) der lokal erzeugte Takt ist.

3. Vorrichtung nach Anspruch 1,
**dadurch gekennzeichnet,**
daß die Steuereinrichtung (ST) einen Pasendetektor (PD) und einen mit diesem in Wirkverbindung stehenden Bitgenerator (PWM) aufweist.

4. Vorrichtung nach Anspruch 1 bis 3,
**dadurch gekennzeichnet,**
daß die Steuerlogik (CONTLOG) in Wirkverbindung mit einer Schaltvorrichtung (S) steht.

5. Vorrichtung nach einem der vorstehenden Ansprüche,
**dadurch gekennzeichnet,**
daß die Takterzeugungsvorrichtung (VCXO) als spannungsgesteuerter Kristall-Oscillator ausgebildet ist.

6. Vorrichtung nach einem der vorstehenden Ansprüche,
**dadurch gekennzeichnet,**
daß in die Mittel zum Rückkoppeln eine PLL-Schaltung (PLL) eingefügt ist, die eine Frequenzverdoppelung des zweiten Taktes (CLOCK) vornimmt.

7. Vorrichtung nach einem der vorstehenden Ansprüche,
**dadurch gekennzeichnet,**
daß die Bitfolge ähnlich einer PWM-Bitfolge ausgebildet ist.

8. Vorrichtung nach einem der vorstehenden Ansprüche,
**dadurch gekennzeichnet,**
daß eine Invertiervorrichtung (I) vorgesehen ist, der eingangsseitig die Bitfolge zugeführt wird und die ausgangsseitig die hierzu invertierte Bitfolge abgibt.
